# EUROPEAN PATENT SPECIFICATION

(11) **EP 4 256 605 B1**
(45) Date of publication and mention of the grant of the patent: **21.10.2026**
(21) Application number: 21835152.6
(22) Date of filing: 01.12.2021
(51) Int. Cl.: H10P 14/46, H10W 20/41

(54) **METALLIZATION OF SEMICONDUCTOR WAFER**
METALLISIERUNG EINES HALBLEITERWAFERS
MÉTALLISATION DE TRANCHE DE SEMI-CONDUCTEUR

(30) Priority: 02.12.2020 CN 202011393016
(43) Date of publication of application: 11.10.2023
(73) Proprietor: Heraeus Printed Electronics GmbH, 63450 Hanau (DE)
(72) Inventor: LIU, Erwei, Shanghai 201108 (CN); WANG, Lan, Shanghai 201108 (CN); BOLDT, Kai-Ulrich, 63450 Hanau (DE); SHEN, Fangzhong, Shanghai 201108 (CN)
(74) Representative: Heraeus IP
(86) International application number: PCT/CN2021/134797
(87) International publication number: WO 2022/116996

(56) References cited:
- US-A1- 2003 104 679
- US-A1- 2003 148 024
- US-A1- 2004 127 025
- US-A1- 2015 132 476
- LOVELL M R ET AL: "Formulation and Processing of Novel Conductive Solution Inks in Continuous Inkjet Printing of 3-D Electric Circuits", IEEE TRANSACTIONS ON ELECTRONICS PACKAGING MANUFACTURING, IEEE, PISCATAWAY, NY, US, vol. 28, no. 3, 1 July 2005 (2005-07-01), pages 265 - 273, XP011139014, ISSN: 1521-334X, DOI: 10.1109/TEPM.2005.852542

## Description

### TECHNICAL FIELD

The present invention relates to a method for manufacturing a semiconductor wafer. In particular, the present invention relates to a method for manufacturing a semiconductor wafer by metallizing the semiconductor wafer.

### TECHNICAL BACKGROUND

During the manufacture of semiconductor devices, it is usually necessary to metallize the semiconductor wafer. The metallization scheme typically must meet the following requirements: firstly, the layer arranged directly on the wafer must adhere to the wafer; secondly, the outer surface of the metallization structure must be solderable to allow the semiconductor device to be bonded to lead frame, etc.; and thirdly, the metallization structure itself must not crack. In addition, metallization requires effective stress control on the stack to reduce additional warpage of the wafer; low ohmic contact resistance and excellent adhesion are also important requirements for the metallization process.

The conventional method for wafer metallization is sputtering/evaporation, where multiple stacked layers are typically used, such as Ti/Ni/Ag, Al/Ti/NiV/Ag, or Ti/Au.

For example, US4946376 discloses a metallization scheme for a semiconductor device comprising a vanadium layer with a thickness of 500 to 3000 Å arranged on the backside of the wafer; and a silver layer with a thickness of 10,000 to 20,000 Å arranged on the vanadium layer, wherein the vanadium layer and the silver layer are applied by evaporation or sputtering.

US6790709B2 discloses a microelectronic device and a manufacturing method thereof. The microelectronic device comprises a microelectronic die having an active surface, a back surface, and at least one side, wherein the microelectronic die comprises a beveled sidewall and a channel sidewall, wherein a metallization layer is arranged on the back surface and the beveled sidewall of the microelectronic die. The metallization layer could be formed by any method known in the art, including but not limited to chemical vapor deposition, sputtering deposition (PVD), electroplating, etc., preferably sputtering deposition.

US2008/0083611A1 discloses a method for improving adhesion between a wafer and a deposited metal film, which comprises bombarding the deposited film with metal ions at a temperature below 200°C, wherein the energy of the metal ions is sufficiently high to achieve interfacial mixing between the metal and the wafer atoms, and wherein the energy of the metal ions is sufficiently low to prevent stress damage to the wafer. The deposited film in this literature is produced by sputtering.

The main drawbacks of the above-mentioned prior art are high equipment costs, low material utilization, and the need for additional hardware (shield/mask) in term of accommodating the wafer size variation (e.g., from 200 mm to 300 mm).

In addition, the prior art also discloses a method for metallization by using printing techniques.

For example, US10763230B2 discloses a method for backside metallization of integrated circuits, comprising forming a wetted layer by inkjet printing a pattern of nanosilver particle conductive ink on a first surface of a silicon wafer, and then curing the wetted layer by heating the wafer in an oven to evaporate the solvent and other materials in the ink.

WO2020/094583A1 discloses a method for manufacturing a semiconductor package at least partially covered by an electromagnetic interference shielding layer, comprising at least the steps of: i. providing a semiconductor package and an ink composition; wherein the ink composition comprises at least the following components: a) a compound comprising at least one metal precursor; and b) at least one organic compound; ii. applying at least a portion of the ink composition to the semiconductor package, wherein a precursor layer is formed; and iii. treating the precursor layer with an electromagnetic radiation of a peak wavelength in the range of 100 nm to 1 mm. In this method, the ink composition is applied to the semiconductor package, i.e., to the epoxy, rather than to the silicon wafer itself, with the aim of providing an electromagnetic interference shielding layer rather than metallizing the wafer.

The document US 2003/148024 Al and the paper by Lovell et al.: "Formulation and Processing of Novel Conductive Solution Inks in Continuous Inkjet Printing of 3-D Electric Circuits", IEEE Trans.Electron.Pack.Manuf. 28(3), disclose prior art methods of forming conductive layers on wafers using MOD inks.

The prior art methods for metallization by printing have several drawbacks: the adhesion and electrical conductivity of the metallization layer still need further improvement.

### SUMMARY OF THE INVENTION

It is an object of the present invention to overcome the disadvantages of the prior art and to provide a method for manufacturing a semiconductor wafer, in particular a method for manufacturing a semiconductor wafer by metallizing the semiconductor wafer, wherein the resultant metallization layer has improved adhesion and electrical conductivity.

Specifically, an object of the present invention is to provide a method for manufacturing a semiconductor wafer as defined in claim 1.

Another object of the present invention is to provide a semiconductor wafer as defined in claim 12, obtained by the method of the present invention.

A further object of the present invention is to provide a semiconductor device comprising the semiconductor wafer of the present invention.

A still further object of the present invention is to provide a semiconductor wafer precursor as defined in claim 14.

### DETAILED DESCRIPTION OF THE INVENTION

In one aspect of the present invention, the present invention provides a method for manufacturing a semiconductor wafer, comprising.
i) applying a MOD ink composition to a semiconductor wafer, thereby forming a precursor layer; and
ii) curing the precursor layer.

The method of the present invention enables the back and/or front side of the semiconductor wafer to be metallized, preferably enabling the backside to be metallized. The metal used is Ag, Ag/Sn or Au. The thickness of the resultant metallization layer may be determined as desired and may, for example, be from about 100 nm to about 3000 nm, preferably from about 300 nm to about 2000 nm, and particularly preferably from about 300 nm to about 1000 nm. The resultant metallization layer has good electrical and thermal conductivity, and also has good solderability to externally attached materials.

The semiconductor wafer may be a Si wafer, a SiC wafer, a GaN wafer, a GaAs wafer or a Ga₂O₃ wafer, preferably a Si wafer. The semiconductor wafer may be a power electronic wafer or a logic IC wafer.

### Step i)

In an embodiment of the present invention, the application in step i) is carried out by spraying, spin coating, dip coating or inkjet printing, preferably by inkjet printing.

Inkjet printing is an additive manufacturing process that reduces material waste and does not require a mask or an etching step. Moreover, inkjet printing can handle large wafers (e.g., 300 mm wafers), which reduces the need for expensive metal deposition equipment for such wafers, which in turn reduces the manufacturing cost.

Inkjet printing can be done in a patterned way. Inkjet printing can be carried out by any type of inkjet printer, such as a piezoelectric inkjet printer. The number of layers applied by inkjet printing can be one or more layers in order to obtain the desired layer thickness, preferably 1 to 10 layers. The layer thickness of inkjet printing can be adjusted by adjusting the printing resolution and the number of layers. The DPI range X/Y for inkjet printing can be 300 to 3000.

The MOD ink composition used in the present invention comprises a precursor compound of the metal to be applied and a solvent. In order to form a film of the metal to be applied (especially silver), the organic solvent needs to be removed so that the metal precursor compound can be transformed into a solid structure by decomposition reaction.

However, during the removal of the solvent, air bubbles may form at the interior or at the surface, especially when the film is thick, which will eventually result in a film with high porosity. Therefore, MOD ink is traditionally considered to be suitable for the preparation of a thin film only, as otherwise quality problems may occur. Moreover, metal films prepared by MOD ink is considered to have poorer adhesion to the substrate compared to those prepared by other methods such as CVD or PVD. It is believed that the only way to reduce the bubble density is to remove the solvent slowly by simply changing the heating rate. Therefore, this method is too slow to be applied in the modern semiconductor industry.

As a result, MOD ink is currently used in the semiconductor industry only to fabricate circuits (i.e., to create conductive pathways), for example, on polyimide (PI) or polyethylene terephthalate (PET) in flexible printed circuit (FPC) applications. For these applications, the metal layer must be thin and uniform, and used in a relatively good environment. For other applications, such as backside metallization, MOD ink is considered unsuitable because the backside metallization layer must be relatively thick and strong to ensure good bonding to the wafer so that the metallization layer does not peel off when the temperature drastically changes or high current density frequently occurs.

Surprisingly, however, it was found that when MOD ink is used in the method of the present invention, a dense layer with large thickness and with small porosity can be obtained in one application and curing cycle at a fast rate by fully curing it in a curing step after application (called application and curing cycle). On the other hand, it is also possible to implement multiple application and curing cycles and form a layer with a thickness of 100 nm to 800 nm, preferably 150 nm to 500 nm, more preferably 200 nm to 300 nm in each cycle, thus obtaining a dense layer with large thickness and with small porosity and large grains (up to 1000 nm) at a fast rate. The resultant layer has good adhesion and electrical conductivity, thus making it possible to use MOD ink for backside metallization of wafer, thus overcoming the bias of the prior art. The layer obtained by the method of the present invention using MOD ink has a porosity comparable to or even smaller than that of the PVD method.

One of the benefits of MOD ink over other inks, such as nanoparticle ink, is the ability to form more uniform, flatter and denser films. The layer obtained by the ink containing metal nanoparticles is usually very loose, i.e. with high porosity; whereas the layer obtained by the method of the present invention using MOD ink has much lower porosity. Unlike the nanoparticle ink, MOD ink is a solution rather than a mixture (suspension), which does not settle over time and causes fewer problems during application (e.g., less likely to clog nozzles). The viscosity of MOD ink can be easily adjusted in order to adjust sprayability and the annealing temperature. In addition, MOD ink is environmentally friendly, does not contain nanoparticles, is more readily available, and can ultimately be cheaper than the nanoparticle ink.

The MOD ink composition used in the present invention comprises the following components: a) at least one metal precursor; and b) a solvent.

The metal in the MOD ink composition is Ag, Ag/Sn or Au.

The metal precursor has a decomposition temperature of 80°C to 500°C, for example 80°C to 500°C, or 150°C to 500°C, or 180°C to 350°C, or 150°C to 300°C, or 180°C to 270°C.

The metal precursor consists of:
a) at least one metal cation; and
b) at least one anion selected from the group consisting of carboxylate, carbamate, nitrate, halide ion and oxime.

A combination of two or more metal precursors may be used, the two or more metal precursors having the same metal cation but the same or different types of anions; or having different metal cations but having the same type of anion. This includes, for example, the combination of silver carboxylate and tin carboxylate, the combination of two different silver carboxylates, and the combination of silver carboxylate and silver carbamate.

A carboxylate is a salt consisting of one or more metal cations and one or more carboxylate anions. The carboxylic acid portion of the carboxylate anion may be linear or branched, or have a cyclic structural unit, and may be saturated or unsaturated. Further preferred types of carboxylates are a monocarboxylate and a dicarboxylate, or a cyclic carboxylate. In an embodiment, a linear saturated carboxylate is preferred, such as a carboxylate having 1 to 20 carbon atoms. The linear carboxylate can be selected from the group consisting of acetate, propionate, butyrate, valerate, hexanoate, heptanoate, octanoate, nonanoate, decanoate, undecanoate, dodecanoate, tetradecanoate, hexadecanoate or octadecanoate. In another embodiment, a saturated isocarboxylate and a saturated neocarboxylate having 1 to 20 carbon atoms may be used. In an embodiment, a saturated neocarboxylate having 5 or more carbon atoms, such as neopentanoate, neohexanoate, neoheptanoate, neooctanoate, neononanoate, neodecanoate, and neododecanoate, is preferred.

The halide ion is selected from the group consisting of fluoride ion, chloride ion, bromide ion and iodide ion.

The metal content of the MOD ink composition is from about 1 wt% to about 60 wt%, e.g. from about 1 wt% to about 50 wt% or from about 10 wt% to about 40 wt%, calculated in metal, based on the total weight of the ink composition, as is usually determined by thermogravimetric analysis (TGA).

The MOD ink composition further comprises a solvent. The MOD ink composition comprises from about 0.1 wt% to about 90 wt%, preferably from about 20 wt% to about 90 wt% of solvent, in each case based on the total weight of the MOD ink composition.

As the solvent, a solvent selected from the group consisting of a glycol ether, a terpene, an aliphatic hydrocarbon, an aromatic hydrocarbon, a ketone, an aldehyde, or a combination thereof, can be used.

The glycol ether is an organic substance having at least one diol unit. As the glycol ether, ethylene glycol ether, diethylene glycol ether, triethylene glycol ether, tetraethylene glycol ether, propylene glycol ether, dipropylene glycol ether, and the like can be mentioned. Commercially available examples are DOWANOL PNP (propylene glycol n-propyl ether) and DOWANOL PNB (propylene glycol n-butyl ether), DOWANOL DPNB (dipropylene glycol n-butyl ether) and DOWANOL DPNP (dipropylene glycol n-propyl ether).

The terpene is a naturally occurring unsaturated hydrocarbon that can be isolated from natural substances and whose structure can be traced to one or more isoprene units. Some terpenes are also available industrially and artificially. Terpene is preferably an acyclic terpene or a cyclic terpene. Among the cyclic terpene, a monocyclic terpene is preferred. Preferably, the terpene is selected from orange terpene, limonene and pinene or a combination thereof.

Other suitable solvents such as aliphatic hydrocarbons, aromatic hydrocarbons, ketones, and aldehydes are well known in the art.

The MOD ink composition may optionally comprise one or more other components, such as adhesion promoter, viscosity aid and other additives.

In an embodiment, the MOD ink composition may comprise an adhesion promoter, preferably the content of the adhesion promoter may be from about 0.1 wt% to about 5 wt%, based on the total weight of the MOD ink composition.

In an embodiment, the MOD ink composition may comprise one or more viscosity aids in a weight ratio of from about 5 wt% to about 30 wt%, more preferably from about 10 wt% to about 20 wt%, based on the total weight of the ink composition.

Rosin resin or derivatives thereof is a suitable viscosity aid for the ink compositions. A particularly preferred commercial product is a balsam resin available from H. Reynaud & Fils GmbH, Hamburg.

In an embodiment, the MOD ink composition may comprise other additives in a proportion of from about 0.05 wt% to about 3 wt%, more preferably from about 0.05 wt% to about 1 wt%, in each case based on the total weight of the ink composition. All chemicals known to those skilled in the art to be suitable as ink additives can be used as other additives. Particularly preferred are a siloxane-containing additive, such as a polyether-modified polydimethylsiloxane.

In an embodiment, the MOD ink composition comprises less than 1 wt%, or less than 0.5 wt%, or less than 0.2 wt% of metallic particles based on the total weight of the MOD ink composition. Most preferably, the composition of the present invention is practically free of metal particles.

The MOD ink composition may have a viscosity suitable for application, such as an ink composition having a viscosity of from about 0.1 to about 100 mPa•s, such as from about 5 to about 30 mPa•s, measured at a temperature of 20°C and an ambient pressure of 1013 hPa.

The components in the MOD ink composition may be mixed in all the ways known and considered suitable by those skilled in the art. Mixing can be done at a slightly elevated temperature to facilitate the mixing process. Typically, the temperature during mixing does not exceed 40°C. The ink compositions can be stored at room temperature or in a refrigerator.

### Step ii)

In step ii), the precursor layer obtained in step i) is cured. During curing, the solvent in the wet layer evaporates and triggers nucleation within the layer.

Since the metal Ag, Ag/Sn or Au in the MOD ink used in step i) is not susceptible to oxidation, curing can be carried out in air. Of course, curing can also be carried out under an inert atmosphere. Examples of the inert atmosphere include, but are not limited to, nitrogen, helium, argon and neon, etc.

The curing in step ii) may be carried out by heating and/or electromagnetic radiation. In an embodiment of the present invention, heating and electromagnetic radiation may be carried out simultaneously; or heating followed by electromagnetic radiation; or electromagnetic radiation followed by heating.

When curing is carried out by heating, this may be carried out in an oven. The heating temperature may be from about 50°C to about 250°C, preferably from about 80°C to about 200°C, more preferably from about 150°C to about 200°C, and the heating time may be from about 1 to about 60 minutes, preferably from about 5 to about 40 minutes.

When curing is carried out by electromagnetic radiation, electromagnetic radiation with a wavelength of from about 100 nm to about 1 mm, preferably from about 100 nm to about 2000 nm, more preferably from about 100 nm to about 800 nm, may be used. The radiation intensity may be from about 100 W/cm² to about 1000 W/cm², preferably from about 100 W/cm² to about 500 W/cm², more preferably from about 100 W/cm² to about 400 W/cm². The radiation rate may be from about 0.01 mm/s to about 1000 mm/s, preferably from about 0.1 mm/s to about 500 mm/s, more preferably from about 0.1 mm/s to about 50 mm/s. The radiation may be carried out for 1 to 100 passes, preferably 1 to 50 passes.

In an embodiment of the present invention, the cycle comprising steps i) and ii) is carried out for one or more times, wherein in each cycle, step i) is carried out for one or more times and step ii) is carried out for one or more times. For example, the cycle may be carried out for 1 to 10 times, preferably 1 to 5 times, more preferably 1 to 3 times; in each cycle, step i) is carried out for 1 to 10 times, preferably 1 to 5 times, more preferably 1 to 3 times, and step ii) is carried out for 1 to 10 times, preferably 1 to 5 times, more preferably 1 to 3 times.

In the case of carrying out multiple cycles, a layer with a thickness of from 100 nm to 800 nm, preferably from 150 nm to 500 nm, more preferably from 200 nm to 300 nm, is formed in each cycle.

### Other steps

The method of the present invention may further comprise step iii), i.e., annealing the layer obtained in step ii).

The annealing temperature is related to the melting point of the metal, with higher annealing temperatures being used for metals having higher melting points. The annealing temperature may be from about 120°C to about 500°C, preferably from about 150°C to about 460°C. The annealing time is also related to the melting point of the metal, with longer annealing times being used for metals having higher melting points. The annealing time may be from about 1 to about 60 minutes, preferably from about 5 to about 40 minutes, more preferably from about 5 to about 30 minutes.

Since the metal Ag, Ag/Sn or Au in the MOD ink used in step i) is not susceptible to oxidation, annealing can be carried out in air. Of course, annealing can also be carried out under an inert atmosphere. Examples of the inert atmosphere include, but are not limited to, nitrogen, helium, argon and neon, etc.

Annealing can be carried out in any suitable equipment, for example in a tube furnace.

The method of the present invention may also comprise other steps, such as the step of cleaning the semiconductor wafer.

In an embodiment of the present invention, the semiconductor wafer may be cleaned to remove any possible oxides on the surface before each layer (e.g., the MOD ink composition layer) is applied to the semiconductor wafer or before each layer (e.g., the MOD ink composition layer) is applied to other layer already present on the semiconductor wafer. The presence of oxides can increase contact resistance and affect adhesion, which in turn may affect the performance of the product. In addition, cleaning can remove residual contaminants from the surface as well as enhance the adhesion of the film by activating the chemical bonds on the surface. Alternatively, the oxide layer on the surface can also be retained during the cleaning process.

As the cleaning method, plasma cleaning and chemical cleaning may be mentioned. Preferably, cleaning is carried out by using plasma. As examples of plasma cleaning, Ar plasma cleaning, air plasma cleaning or vacuum plasma cleaning may be mentioned. The time for plasma cleaning may be from about 1 to about 60 minutes, preferably from about 1 to about 10 minutes. Suitable chemical cleaning methods are well known in the art.

After the semiconductor wafer has been cleaned, a base layer is applied to it. Suitable base layers are an adhesion layer and a barrier layer, wherein the adhesion layer is in direct contact with the silicon wafer surface and the barrier layer is disposed on top of the adhesion layer to prevent oxidation of the adhesion layer and interdiffusion between the adhesion layer and the subsequent Ag, Ag/Sn or Au layer (as described above). Of course, a layer with both adhesion and barrier functions can also be applied.

Specifically, the method of the present invention further comprises the following steps carried out prior to step i):
1) forming an adhesion layer and a barrier layer on the semiconductor wafer; or
2) forming a layer having both adhesion and barrier functions on the semiconductor wafer.

Surprisingly, it was found that wafers comprising a layer with both adhesion and barrier functions as well as Ag, Ag/Sn or Au layer have excellent thermal and electrical conductivity.

The application of the base layer is carried out by spraying, spin coating, dip coating or inkjet printing, preferably by inkjet printing. When spraying, spin coating, dip coating or inkjet printing is used, a MOD ink composition comprising the precursor of the metal to be applied is also used. The MOD ink compositions used are such as those described above for Ag, Ag/Sn or Au layer, the difference being that the metal used is the one used for the base layer.

The inkjet printing of the base layer can also be carried out in a patterned manner. Inkjet printing is carried out by an inkjet printer, preferably a piezoelectric inkjet printer. The number of layers applied by inkjet printing can be one or more layers, preferably 1 to 10 layers. The layer thickness of inkjet printing can be adjusted by adjusting the printing resolution and the number of layers. The DPI range X/Y for inkjet printing can be 300 to 3000.

After the application of the base layer, the resultant base layer may be cured and annealed as described above. In the present invention, the curing and annealing treatments may sometimes be referred to collectively as "post-treatment".

When applying an adhesion layer and a barrier layer to a semiconductor wafer, this can be done by (i) applying one or more adhesion layers, curing and/or annealing the adhesion layers, then applying one or more barrier layers, and curing and/or annealing the barrier layers; or (ii) applying one or more adhesion layers, then applying one or more barrier layers, then curing and/or annealing the resultant composite layer together. In the case of (i), when a plurality of adhesion layers are applied, it is possible to apply each adhesion layer, then cure and/or anneal that layer, then apply the next adhesion layer, then cure and/or anneal that next adhesion layer ..., etc., until the desired thickness is obtained; it is also possible to cure and/or anneal all of the applied adhesion layers together after a plurality of adhesion layers have been applied. Similarly, in the case of (i), when a plurality of barrier layers are applied, it is possible to apply each barrier layer, then cure and/or anneal that barrier layer, then apply the next barrier layer, then cure and/or anneal that next barrier layer ..., etc., until the desired thickness is obtained; it is also possible to cure and/or anneal all of the applied barrier layers together after a plurality of barrier layers have been applied.

Curing is carried out by electromagnetic radiation and/or heating. When curing is carried out by heating, the heating temperature is from about 50°C to about 250°C, preferably from about 80°C to about 200°C, more preferably from about 150°C to about 200°C, and the heating time is from about 1 to about 60 minutes, preferably from about 5 to about 40 minutes. When curing is carried out by electromagnetic radiation, electromagnetic radiation with a wavelength of from about 100 nm to about 1 mm, preferably from about 1000 nm to about 2000 nm, more preferably from about 100 nm to about 800 nm, may be used. For curing of the adhesin and barrier layers, the radiation intensity may be from about 1 W/cm² to about 100 W/cm², preferably from about 10 W/cm² to about 50 W/cm². The radiation rate may be from about 0.01 mm/s to about 1000 mm/s, preferably from about 0.1 mm/s to about 500 mm/s, more preferably from about 0.1 mm/s to about 50 mm/s. The radiation may be carried out for 1 to about 100 passes, preferably from 1 to about 50 passes.

If the metals in the MOD ink used for the base layer are susceptible to oxidation, for example for Ti, and Ni, annealing under an inert atmosphere is required to prevent oxidation of the metals due to their tendency to convert to oxides during curing. If the metals in the MOD ink used for the base layer are not susceptible to oxidation, for example for Pt, Ag and Au, curing can be carried out in air; of course, curing under inert atmosphere is also possible. Examples of the inert atmosphere include, but are not limited to, nitrogen, helium, argon and neon, etc.

The annealing temperature may be from about 120°C to about 500°C, preferably from about 150°C to about 460°C. The annealing time is also related to the melting point of the metal, with longer annealing time being used for a metal having a higher melting point. The annealing time may be from about 1 to about 60 minutes, preferably from about 5 to about 40 minutes, more preferably from about 5 to about 30 minutes. As mentioned above, depending on the metal used, annealing of the base layer may be carried out under a reducing atmosphere or an inert atmosphere.

The metals used in the adhesion layer may be titanium (Ti), bismuth (Bi), tin (Sn), aluminum (Al), chromium (Cr), vanadium (V), yttrium (Y), cerium (Ce), silicon (Si), tin (Sn), zinc (Zn), or a mixture thereof. The metal used in the barrier layer may be nickel (Ni), vanadium (Vi), chromium (Cr), or a mixture thereof such as nickel-vanadium (NiV). For a layer with both adhesion and barrier functions, the preferred metals are bismuth (Bi), nickel-vanadium (NiV) or tungsten (W), more preferably Bi.

The thickness of the adhesion layer may be from 50 nm to 500 nm, preferably from 50 nm to 100 nm. The thickness of the barrier layer may be from 100 nm to 500 nm, preferably from 100 nm to 200 nm. The thickness of the layer having both adhesion and barrier functions may be from 30 nm to 500 nm, preferably from 50 nm to 100 nm.

It should be noted that in the context of the present invention, although the adhesion layer and the barrier layer are clearly defined, in the actual manufacturing process, the adhesion layer and the barrier layer may fuse at the interface, thus forming an interfacial layer. Embodiments of the method of the present invention

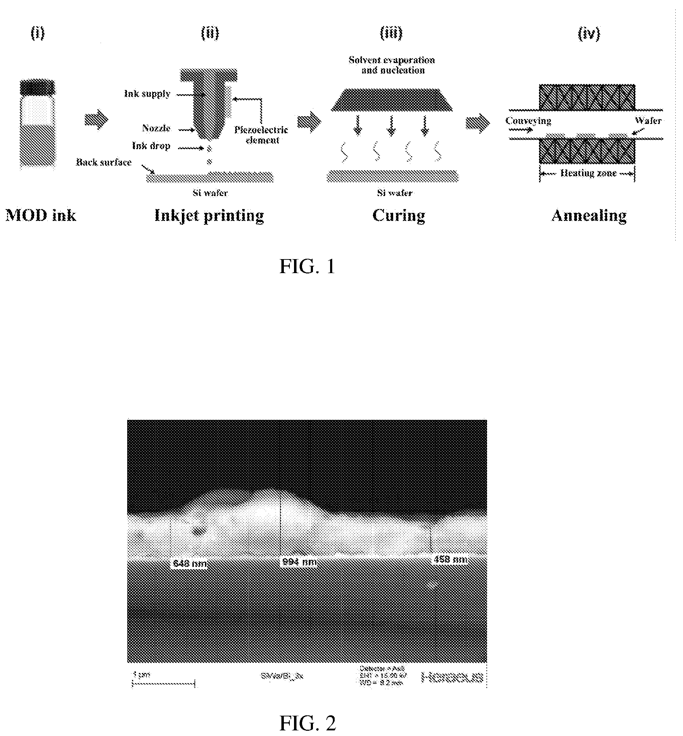

FIG. 1 illustrates an embodiment of the method of the present invention, comprising:
(i) formulating MOD (metal precursor + solvent);
(ii) inkjet printing a wet layer on the backside of the wafer with the MOD ink filled in a piezoelectric press, wherein the layer thickness can be adjusted by adjusting the printing resolution and the number of layers;
(iii) curing the wet printed layer by electromagnetic radiation to evaporate the solvent and nucleate;
(iv) annealing the cured layer in a tube oven;
wherein steps (ii) and (iii) together can be carried out for one or more times to obtain the desired layer thickness.

In a preferred embodiment, the present invention relates to a method for manufacturing a semiconductor wafer comprising:
1) plasma cleaning the wafer;
2) inkjet printing an adhesion layer;
3) post-treating the adhesion layer;
4) inkjet printing a barrier layer;
5) post-treating the barrier layer;
6) inkjet printing a Ag, Ag/Sn or Au layer; and
7) post-treating the silver layer;

Wherein the post-treating conditions for the adhesion layer/barrier layer are
- curing: radiation intensity of 1 W/cm² to 100 W/cm², wavelength of 100 nm to 1 mm, and rate of 0.1 mm/s to 1000 mm/s, for 1 to 100 passes; and
- annealing: 120°C to 500°C for 1 to 30 minutes.

The post-treating conditions for the Ag, Ag/Sn or Au layer are
- curing: radiation intensity of 100 W/cm² to 1000 W/cm², wavelength of 100 nm to 1 mm, and rate of 0.1 mm/s to 100 mm/s, for 1 to 100 passes; and
- annealing: 120°C to 500°C for 1 to 30 minutes.

### Advantages of the method of the present invention

The present invention utilizes a MOD ink to deposit different thin film layers on the backside of silicon wafer, aiming for wafer metallization applications in semiconductor devices. This can save equipment costs and reduce material waste. In particular, in the preferred embodiment of the present invention, inkjet printing is used to apply the MOD ink, which allows the use of industrial-scale piezoelectric inkjet presses to manufacture films, which is an additive manufacturing process, with the main advantages of
1. low equipment cost and low power consumption (no vacuum required);
2. no material waste; and
3. on-demand printing for easy selective deposition/design flexibility (no etching required).

Wafers obtained by inkjet printing of a MOD ink and post-treating according to the present invention have a different layer microstructure compared to the layer manufactured by PVD or nanoparticle ink. The prior art PVD results in a very dense layer, on the other hand, the use of the ink containing nanometallic particles of the prior art usually results in a layer with small aggregates and high porosity. In contrast, the MOD layer of the present invention has a dense structure containing large grains after annealing, and the morphology of each layer can be easily adjusted by adjusting the post-treating conditions. This results in an excellent electrical conductivity of the Ag, Ag/Sn or Au layer of the present invention. In particular, the electrical conductivity of the Ag, Ag/Sn or Au layer obtained by the method of the present invention is higher than that of the layer obtained by using the nanometallic ink in the prior art, and comparable to that of the layer obtained by using the PVD method in the prior art.

### Other aspects of the present invention

In another aspect of the present invention, there is provided a semiconductor wafer obtained by the method of the present invention.

In yet another aspect of the present invention, there is provided a semiconductor device comprising the semiconductor wafer of the present invention.

In a further aspect of the present invention, there is provided a semiconductor wafer precursor comprising: a) a semiconductor wafer; and b) an uncured MOD ink layer.

### BRIEF DESCRIPTION OF THE DRAWINGS

FIG. 1 illustrates a schematic diagram of the method of the present invention.
FIG. 2 illustrates an electron microscopy image of the cross section of the bismuth oxide/silver stack of Example 2.

### Examples

The purpose of the following examples is to further illustrate the present invention but not to limit the scope of the present invention.

### Test Method

To measure the square resistivity of the layer obtained by the method of the present invention, a four-point probe obtained from Ossila, Sheffield, UK was used.

### Peel-off test

The adhesion of the metallization layer to the wafer was characterized by a peel-off test. The peel-off test standard was ASTM D3359-09.

### Example 1, not forming part of the invention as claimed.

In the Example, the Ti/Ni layer as the adhesion layer and the barrier layer was carried out by using PVD (obtained from Shanghai Yuquan Trading Co., Ltd.), and the silver layer was carried out by using MOD ink and by the inkjet printing method, with the following parameters for each layer:
- adhesion layer: Ti, 50 nm;
- barrier layer: Ni, 100 nm;
- silver layer: Ag, 300 nm.

The process flow was as follows;
1. Ar plasma cleaning for 5 minutes;
2. PVD Ti, thickness of 50 nm;
3. PVD Ni, thickness of 100 nm;
4. Using an inkjet printer from Heraeus, print head model: RICOH MH5421F inkjet printing a MOD silver ink, DPI 1200*1600, 1 layer. The MOD silver ink consisted of 15 wt% silver neodecanoate and 85 wt% limonene (DL-limonene, CAS No. 138-86-3, obtained from Merck KGaA, catalog No. 814546), each based on the total weight of the ink;
5. Curing of the silver ink layer by using Heraeus UV curing equipment Heraeus Semray 4103 (wavelength: 395 nm, rate: 1 mm/s, 1 pass, radiation intensity of 250 W/cm²);
6. Annealing by using SG-XL1200 annealing equipment under the different conditions shown in the table below.

The obtained metallization layers were tested, and the results are shown in the following table.

| Sample | Annealing conditions | Square resistance (mOhm/Sq) | Peel-off test results |
|---|---|---|---|
| 1# | Annealed at 350°C for 10 minutes | 62 | 4B |
| 2# | Heated up from room temperature to 350°C at a rate of 10°C/min, then annealed at 350°C for 10 minutes | 64 | 5B |
| 3# | Dried at 100°C for 10 minutes, then annealed at 350°C for 10 minutes | 64 | 4B |

The adhesion performance of the entire metallization layer (Ti+Ni+Ag layer) on the wafer was tested with good results, passing 4B/5B with a square resistance of about 64 mΩ/sq for the Ag layer. For different annealing conditions, there was essentially no difference in the peel-off test and square resistance.

### Example 2

In the Example, the MOD ink was used and all layers were applied by the inkjet printing method. The parameters of each layer were as follows:
- Printed layer with both adhesion and barrier functions: bismuth oxide, 60 nm; and
- Printed silver layer: Ag, 590 nm.

The process flow was as follows.
1. Inkjet printing of the adhesion and barrier layer: Using an inkjet printer of Heraeus, print head model: RICOH MH5421F; MOD bismuth ink, DPI: 564*564, 1 layer. The MOD bismuth ink consisted of 15 wt% bismuth neodecanoate and 85% wt% Dowanol PNP (propylene glycol n-propyl ether, CAS No. 1569-01-3, obtained from The Dow Chemical Company, Inc., Maryland, USA), each based on the total weight of the ink;
2. Drying at 100°C for 10 minutes and annealing at 450°C for 10 minutes by using SG-XL1200 annealing equipment;
3. Printing MOD silver ink using a inkjet printer of Heraeus with printhead model: RICOH MH5421F inkjet, DPI: 1270*1270, 3 layers. The MOD silver ink consisted of 15 wt% silver neodecanoate and 85 wt% limonene (DL-limonene, CAS No. 138-86-3, obtained from Merck KGaA, catalog No. 814546), each based on the total weight of the ink;
4. Drying at 100°C for 10 minutes and annealing at 450°C for 10 minutes by using SG-XL1200 annealing equipment.

The adhesion performance of the entire metallization layer (bismuth oxide + silver layer) on the wafer was tested with good results, passing 5B with a square resistance of about 42 mΩ/sq for the Ag layer.

FIG. 2 illustrates an electron microscopic image of the cross section the bismuth oxide/silver stacked layer of the present Example. From Fig. 2, it can be seen that the bismuth oxide layer was in good contact with the substrate as well as the silver layer with the bismuth oxide layer, and the film structure was very dense with low porosity.

## Claims

1. A method for manufacturing a semiconductor wafer, comprising:
i) applying a metal-organic decomposition (MOD) ink composition to a semiconductor wafer, thereby forming a precursor layer, wherein the metal in the MOD ink composition is Ag, Ag/Sn or Au, and
ii) curing the precursor layer
wherein the method further comprises the steps carried out prior to step i) of
1) forming an adhesion layer and a barrier layer on the semiconductor wafer; or
2) forming a layer having both adhesion and barrier functions on the semiconductor wafer,
wherein the formation of the layers in 1) or 2) is carried out by spraying, spin coating, dip coating or inkjet printing, the ink used is a MOD ink composition.

2. The method according to claim 1, wherein the application in step i) is carried out by spraying, spin coating, dip coating or inkjet printing, preferably by inkjet printing.

3. The method according to any one of claims 1 or 2, wherein the curing in step ii) is carried out by electromagnetic radiation and/or heating wherein the heating temperature is from 50°C to 500°C, preferably from 80°C to 400°C, more preferably from about 150°C to 300°C,
wherein the radiation intensity is from 100 W/cm² to 1000 W/cm², preferably from 100 W/cm² to 500 W/cm², more preferably from 100 W/cm² to 400 W/cm², and the radiation wavelength is from 100 nm to 1 mm, preferably from 100 nm to 2000 nm, more preferably from 100 nm to 800 nm.

4. The method according to any one of claims 1 to 3, further comprising
iii) annealing the layer obtained after curing, wherein the annealing in step iii) is carried out at a temperature of from 120°C to 500°C.

5. The method according to any one of claims 1 to 4, wherein the method causes the backside of the semiconductor wafer to be metallized and/or the front side to be metallized, preferably the backside to be metallized.

6. The method according to any one of claims 1 to 5, wherein the semiconductor wafer is a Si wafer, a SiC wafer, a GaN wafer, a GaAs wafer, or a Ga₂O₃ wafer, preferably a Si wafer.

7. The method according to any one of claims 1 to 6, wherein the semiconductor wafer is a power electronic wafer or a logic IC wafer.

8. The method according to any one of claims 1 to 7, wherein the MOD ink composition comprises: a) at least one metal precursor; and b) a solvent., wherein the metal precursor has a decomposition temperature of from 80°C to 500°C, wherein the metal in the MOD ink composition is Ag, Ag/Sn or Au.

9. The method according to any one of claims 8, wherein the metal precursor consists of:
a) at least one metal cation; and
b) at least one anion selected from the group consisting of carboxylate, carbamate, and oxime.

10. The method according to claim 9,
wherein for 2), the MOD ink composition is a bismuth-containing MOD ink composition.

11. The method according to claim 9 or 10, wherein after each layer of step 1) or 2) is formed, the resultant wafer is cured and/or annealed.

12. A semiconductor wafer obtained by the method according to any one of claims 1 to 11.

13. A semiconductor device comprising the semiconductor wafer according to claim 12.

14. A semiconductor wafer precursor comprising:
a) a semiconductor wafer; and
b) an uncured layer of MOD ink composition wherein the metal in the MOD ink composition is Ag, Ag/Sn or Au, wherein
1) an adhesion layer and a barrier layer is formed on the semiconductor wafer; or
2) a layer having both adhesion and barrier functions is formed on the semiconductor wafer.

## Patentansprüche

1. Verfahren zum Herstellen eines Halbleiterwafers, umfassend:
i) Aufbringen einer Tintenzusammensetzung auf Basis metallorganischer Zersetzung (MOD-Tintenzusammensetzung) auf einen Halbleiterwafer, wodurch eine Vorläuferschicht gebildet wird, wobei das Metall in der MOD-Tintenzusammensetzung Ag, Ag/Sn oder Au ist, und
ii) Aushärten der Vorläuferschicht,
wobei das Verfahren ferner die vor Schritt i) ausgeführten Schritte umfasst von
1) Ausbilden einer Haftschicht und einer Sperrschicht auf dem Halbleiterwafer; oder
2) Ausbilden einer Schicht mit sowohl Haft- als auch Sperrfunktionen auf dem Halbleiterwafer,
wobei die Bildung der Schichten in 1) oder 2) durch Sprühen, Rotationsbeschichten, Tauchbeschichten oder Tintenstrahldrucken durchgeführt wird, wobei die verwendete Tinte eine MOD-Tintenzusammensetzung ist.

2. Verfahren nach Anspruch 1, wobei das Aufbringen in Schritt i) durch Sprühen, Rotationsbeschichten, Tauchbeschichten oder Tintenstrahldrucken, vorzugsweise durch Tintenstrahldrucken, durchgeführt wird.

3. Verfahren nach einem der Ansprüche 1 oder 2, wobei das Aushärten in Schritt ii) durch elektromagnetische Strahlung und/oder Erhitzen durchgeführt wird, wobei die Heiztemperatur von 50 °C bis 500 °C, vorzugsweise von 80 °C bis 400 °C, mehr bevorzugt von etwa 150 °C bis 300 °C beträgt,
wobei die Strahlungsintensität von 100 W/cm² bis 1000 W/cm², vorzugsweise von 100 W/cm² bis 500 W/cm², mehr bevorzugt von 100 W/cm² bis 400 W/cm² beträgt und die Strahlungswellenlänge von 100 nm bis 1 mm, vorzugsweise von 100 nm bis 2000 nm, mehr bevorzugt von 100 nm bis 800 nm beträgt.

4. Verfahren nach einem der Ansprüche 1 bis 3, ferner umfassend
iii) Tempern der nach dem Aushärten erhaltenen Schicht, wobei das Tempern in Schritt iii) bei einer Temperatur von 120 °C bis 500 °C durchgeführt wird.

5. Verfahren nach einem der Ansprüche 1 bis 4, wobei das Verfahren bewirkt, dass die Rückseite des Halbleiterwafers metallisiert wird und/oder die Vorderseite metallisiert wird, vorzugsweise die Rückseite metallisiert wird.

6. Verfahren nach einem der Ansprüche 1 bis 5, wobei der Halbleiterwafer ein Si-Wafer, ein SiC-Wafer, ein GaN-Wafer, ein GaAs-Wafer oder ein Ga₂O₃-Wafer ist, vorzugsweise ein Si-Wafer.

7. Verfahren nach einem der Ansprüche 1 bis 6, wobei der Halbleiterwafer ein Leistungselektronik-Wafer oder ein Logik-IC-Wafer ist.

8. Verfahren nach einem der Ansprüche 1 bis 7, wobei die MOD-Tintenzusammensetzung umfasst: a) mindestens einen Metallvorläufer; und b) ein Lösungsmittel, wobei der Metallvorläufer eine Zersetzungstemperatur von 80 °C bis 500 °C aufweist, wobei das Metall in der MOD-Tintenzusammensetzung Ag, Ag/Sn oder Au ist.

9. Verfahren nach einem der Ansprüche 8, wobei der Metallvorläufer besteht aus:
a) mindestens einem Metallkation; und
b) mindestens einem Anion, ausgewählt aus der Gruppe bestehend aus Carboxylat, Carbamat und Oxim.

10. Verfahren nach Anspruch 9,
wobei für 2) die MOD-Tintenzusammensetzung eine Bismut enthaltende MOD-Tintenzusammensetzung ist.

11. Verfahren nach Anspruch 9 oder 10, wobei, nachdem jede Schicht von Schritt 1) oder 2) gebildet wurde, der resultierende Wafer ausgehärtet und/oder getempert wird.

12. Halbleiterwafer, der durch das Verfahren nach einem der Ansprüche 1 bis 11 erhalten wird.

13. Halbleitervorrichtung, umfassend den Halbleiterwafer nach Anspruch 12.

14. Halbleiterwafervorläufer, umfassend:
a) einen Halbleiterwafer; und
b) eine ungehärtete Schicht einer MOD-Tintenzusammensetzung, wobei das Metall in der MOD-Tintenzusammensetzung Ag, Ag/Sn oder Au ist, wobei
1) eine Haftschicht und eine Sperrschicht auf dem Halbleiterwafer ausgebildet werden; oder
2) eine Schicht, die sowohl Haft- als auch Sperrfunktionen aufweist, auf dem Halbleiterwafer ausgebildet wird.

## Revendications

1. Procédé de fabrication d'une plaquette de semi-conducteur, comprenant :
i) l'application d'une composition d'encre à décomposition organométallique (MOD) sur une plaquette de semi-conducteur, formant ainsi une couche de précurseur, dans lequel le métal dans la composition d'encre MOD est Ag, Ag/Sn ou Au, et
ii) le durcissement de la couche de précurseur
dans lequel le procédé comprend en outre les étapes réalisées avant l'étape i) de
1) formation d'une couche d'adhérence et d'une couche barrière sur la plaquette de semi-conducteur ; ou
2) formation d'une couche ayant à la fois des fonctions d'adhérence et barrière sur la plaquette de semi-conducteur,
dans lequel la formation des couches dans 1) ou 2) est réalisée par pulvérisation, revêtement par centrifugation, revêtement au trempé ou impression à jet d'encre, l'encre utilisée est une composition d'encre MOD.

2. Procédé selon la revendication 1, dans lequel l'application à l'étape i) est réalisée par pulvérisation, revêtement par centrifugation, revêtement au trempé ou impression à jet d'encre, de préférence par impression à jet d'encre.

3. Procédé selon l'une quelconque des revendications 1 ou 2, dans lequel le durcissement à l'étape ii) est réalisé par rayonnement électromagnétique et/ou chauffage, dans lequel la température de chauffage va de 50 °C à 500 °C, de préférence de 80 °C à 400 °C, plus préférablement d'environ 150 °C à 300 °C,
dans lequel l'intensité de rayonnement va de 100 W/cm² à 1 000 W/cm², de préférence de 100 W/cm² à 500 W/cm², plus préférablement de 100 W/cm² à 400 W/cm², et la longueur d'onde de rayonnement va de 100 nm à 1 mm, de préférence de 100 nm à 2 000 nm, plus préférablement de 100 nm à 800 nm.

4. Procédé selon l'une quelconque des revendications 1 à 3, comprenant en outre
iii) le recuit de la couche obtenue après durcissement, dans lequel le recuit de l'étape iii) est réalisé à une température allant de 120 °C à 500 °C.

5. Procédé selon l'une quelconque des revendications 1 à 4, dans lequel le procédé provoque la métallisation de la face arrière de la plaquette de semi-conducteur et/ou la métallisation de la face avant, de préférence la métallisation de la face arrière.

6. Procédé selon l'une quelconque des revendications 1 à 5, dans lequel la plaquette de semi-conducteur est une plaquette de Si, une plaquette de SiC, une plaquette de GaN, une plaquette de GaAs ou une plaquette de Ga₂O₃, de préférence une plaquette de Si.

7. Procédé selon l'une quelconque des revendications 1 à 6, dans lequel la plaquette de semi-conducteur est une plaquette d'électronique de puissance ou une plaquette de CI logique.

8. Procédé selon l'une quelconque des revendications 1 à 7, dans lequel la composition d'encre MOD comprend : a) au moins un précurseur métallique ; et b) un solvant, dans lequel le précurseur métallique a une température de décomposition allant de 80 °C à 500 °C, dans lequel le métal dans la composition d'encre MOD est Ag, Ag/Sn ou Au.

9. Procédé selon l'une quelconque des revendications 8, dans lequel le précurseur métallique est constitué :
a) d'au moins un cation métallique ; et
b) d'au moins un anion choisi dans le groupe constitué de carboxylate, de carbamate et d'oxime.

10. Procédé selon la revendication 9,
dans lequel pour 2), la composition d'encre MOD est une composition d'encre MOD contenant du bismuth.

11. Procédé selon la revendication 9 ou 10, dans lequel, après chaque couche de l'étape 1) ou 2), la plaquette résultante est durcie et/ou recuite.

12. Plaquette de semi-conducteur obtenue par le procédé selon l'une quelconque des revendications 1 à 11.

13. Dispositif de semi-conducteur comprenant la plaquette de semi-conducteur selon la revendication 12.

14. Précurseur de plaquette de semi-conducteur comprenant :
a) une plaquette de semi-conducteur ; et
b) une couche non durcie de composition d'encre MOD, dans lequel le métal dans la composition d'encre MOD est Ag, Ag/Sn ou Au, dans lequel
1) une couche d'adhérence et une couche barrière sont formées sur la plaquette de semi-conducteur ; ou
2) une couche ayant à la fois des fonctions d'adhérence et barrière est formée sur la plaquette de semi-conducteur.
